# EUROPEAN PATENT APPLICATION

(11) **EP 4 122 710 A1**
(43) Date of publication of application: **25.01.2023**
(21) Application number: 21772042.4
(22) Date of filing: 03.03.2021
(51) Int. Cl.: B41J 2/447, B41J 2/45, G03G 15/04, H01L 33/00, H01L 33/58, H01L 33/62, H04N 1/19

(54) **LIGHT-EMITTING ELEMENT ARRAY AND LIGHT PRINT HEAD PROVIDED WITH SAME, AND IMAGE FORMING DEVICE**

(30) Priority: 19.03.2020 JP 2020049512
(71) Applicant: Kyocera Corporation, Kyoto-shi Kyoto 612-8501 (JP)
(72) Inventor: WATANABE,Takanori, Kyoto-shi, Kyoto 612-8501 (JP); TAKEUCHI,Taro, Kyoto-shi, Kyoto 612-8501 (JP)
(74) Representative: Viering, Jentschura & Partner mbB Patent- und Rechtsanwälte
(86) International application number: PCT/JP2021/008100
(87) International publication number: WO 2021/187101

(57) **Abstract**

A light-emitting element array includes a semiconductor substrate that is rectangular, a plurality of light-emitting elements on the semiconductor substrate in a row along a first long side of the semiconductor substrate, a plurality of electrode pads on the semiconductor substrate in a plurality of rows along a second long side of the semiconductor substrate, and a plurality of wires on the semiconductor substrate to connect the plurality of light-emitting elements to the plurality of electrode pads. The plurality of electrode pads in the plurality of rows includes a first electrode pad in a row of the plurality of rows closest to the second long side and having a larger area than a second electrode pad in another row of the plurality of rows.

## Description

### TECHNICAL FIELD

The present disclosure relates to a light-emitting element array included in an optical printer head used as an exposure unit in an image forming apparatus such as an electrophotographic printer, an optical printer head including the light-emitting element array, and an image forming apparatus.

### BACKGROUND OF INVENTION

An image forming apparatus such as an electrophotographic optical printer may include, as an exposure unit, an optical printer head including a light-emitting element array including multiple light-emitting diodes arranged in a main scanning direction.

An image forming apparatus including an optical printer head allows light-emitting diodes in a light-emitting element array to selectively emit light based on image data. The light is applied to an electrophotographic photoreceptor through a lens array in the optical printer head to expose, to the light, the surface of the electrophotographic photoreceptor (also referred to as a photoreceptor) that is charged uniformly. An electrostatic latent image is formed on the exposed surface of the photoreceptor. A process such as development using toner can convert the electrostatic latent image formed on the photoreceptor into a toner image, and transfers and fixes the toner image onto a recording sheet to record the image.

Such an optical printer head includes multiple light-emitting element arrays each including multiple light-emitting diodes and arranged in rows in a main scanning direction.

To improve image quality, the light-emitting element arrays in the optical printer head are to have higher resolution, or more specifically, to include light-emitting elements that are arranged more densely. For more densely arranged light-emitting elements, wires and electrode pads for supplying drive power to the light-emitting elements are arranged more densely.

The densely arranged electrode pads affect the reliability of wire bonding to the electrode pads. Light-emitting element arrays have thus been developed for reliable wire bonding (refer to, for example, Japanese Unexamined Patent Publication No. 11-235843).

### SUMMARY

In an aspect of the present disclosure, a light-emitting element array includes a semiconductor substrate that is rectangular, a plurality of light-emitting elements on the semiconductor substrate in a row along a first long side of the semiconductor substrate, a plurality of electrode pads on the semiconductor substrate in a plurality of rows along a second long side of the semiconductor substrate to correspond one to one to the plurality of light-emitting elements, and a plurality of wires on the semiconductor substrate each connecting a corresponding light-emitting element of the plurality of light-emitting elements to a corresponding electrode pad of the plurality of electrode pads. The plurality of electrode pads in the plurality of rows includes a first electrode pad in a row of the plurality of rows closest to the second long side and having a larger area than a second electrode pad in another row of the plurality of rows.

In another aspect of the present disclosure, an optical printer head includes the light-emitting element array according to the above aspect of the present disclosure, a drive circuit electrically connected to the light-emitting element array to drive the plurality of light-emitting elements, and a lens unit optically coupled to the light-emitting element array.

In another aspect of the present disclosure, an image forming apparatus includes the optical printer head according to the above aspect of the present disclosure, a drive power supply electrically connected to the drive circuit to drive the plurality of light-emitting elements, and an electrophotographic photoreceptor having a surface configured to be charged and exposed to light by the optical printer head.

### BRIEF DESCRIPTION OF THE DRAWINGS

FIG. 1 is a plan view of a first example light-emitting element array according to one or more embodiments of the present disclosure.
FIG. 2 is a plan view of a second example light-emitting element array according to one or more embodiments of the present disclosure.
FIG. 3 is a plan view of a third example light-emitting element array according to one or more embodiments of the present disclosure.
FIGs. 4A and 4B are cross-sectional views of an example electrode pad in a light-emitting element array according to one or more embodiments of the present disclosure.
FIG. 5 is a plan view of an example optical printer head according to one or more embodiments of the present disclosure.
FIG. 6 is a schematic cross-sectional view of an example image forming apparatus according to one or more embodiments of the present disclosure.

### DESCRIPTION OF EMBODIMENTS

To supply drive power to light-emitting elements that are arranged more densely in a light-emitting element array, the corresponding electrode pads are arranged densely. The light-emitting element array includes a rectangular semiconductor substrate, multiple light-emitting elements arranged along a first long side of the semiconductor substrate, for example, in a row, and multiple electrode pads arranged along a second long side of the semiconductor substrate. To densely arrange the electrode pads with a larger area than the light-emitting elements, the electrode pads are arranged in multiple rows such as two or three rows, as described in Japanese Unexamined Patent Publication No. 11-235843.

However, the electrode pads each tend to have a smaller area to increase packaging density, and thus a thin wire having a diameter of, for example, about 30 µm or less is used in wire bonding to the corresponding electrode pad. The thin wire tends to have a lower bonding strength to the electrode pads. The wire bonding uses bonding with an ultrasonic wave, and the transmission of the ultrasonic wave tends to be less at an end of the semiconductor substrate. This tends to decrease the bonding strength of the wire.

Thus, the light-emitting element array is to improve the bonding strength of wire bonding to the densely arranged electrode pads.

In one or more embodiments of the present disclosure, a light-emitting element array includes multiple electrode pads arranged in multiple rows. Among the electrode pads, first electrode pads are in a row of the plurality of rows closest to a second long side of a rectangular semiconductor substrate. Each first electrode pad has a larger area than a second electrode pad in another row of the plurality of rows. This can increase the intensity of an ultrasonic wave transmitted during wire bonding to the first electrode pad closer to an end of the substrate. A wire having a larger diameter than a wire used for the second electrode pad can be used for the first electrode pad, thus increasing the bonding strength to the first electrode pad. The resultant light-emitting element array can have higher bonding strength of wire bonding to the densely arranged electrode pads.

The light-emitting element array according to one or more embodiments of the present disclosure, an optical printer head including the light-emitting element array, and an image forming apparatus will now be described with reference to the accompanying drawings.

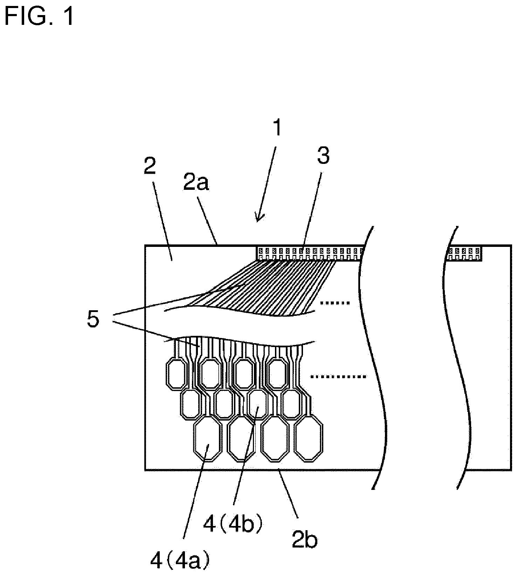

FIG. 1 is a plan view of a first example of the light-emitting element array according to one or more embodiments of the present disclosure. A light-emitting element array 1 illustrated in FIG. 1 includes a semiconductor substrate 2, multiple light-emitting elements 3, multiple electrode pads 4, and multiple wires 5. To simplify the drawings, dotted lines represent the repetition of the electrode pads 4 and the wires 5, and wavy lines represent a portion that may be unused for understanding the disclosure. Thus, FIG. 1 is simplified.

The semiconductor substrate 2 is rectangular in a plan view, and has a first long side 2a and a second long side 2b. The light-emitting elements 3 are arranged in a row along the first long side 2a of the semiconductor substrate 2. The electrode pads 4 correspond to each of the light-emitting elements 3, and are arranged in multiple rows along the second long side 2b of the semiconductor substrate 2. In this example, the electrode pads 4 are arranged in three rows. The electrode pads 4 may be arranged in two rows or four rows. The wires 5 electrically connect the light-emitting elements 3 to the corresponding electrode pads 4. The wires 5 are arranged in an area between the light-emitting elements 3 and the electrode pads 4 on a surface of the semiconductor substrate 2.

Among the electrode pads 4 in the rows in the light-emitting element array 1 according to the embodiments of the present disclosure, the first electrode pads 4a are in a row closest to the second long side 2b of the semiconductor substrate 2. Each first electrode pad 4a has a larger area than a second electrode pad 4b in another row. The electrode pads 4 closer to an end of the semiconductor substrate 2 are less likely to transmit an ultrasonic wave during wire bonding. However, an increase in the intensity of the ultrasonic wave in the first electrode pad 4a with a larger area can improve the bonding strength. In some embodiments, a wire having a larger diameter than the wire used for the second electrode pad 4b can be used for the first electrode pad 4a, thus improving the bonding strength. When, for example, the wire used for the second electrode pad 4b has a diameter of 20 µm to densely arrange the electrode pads, the wire used for the first electrode pad 4a may have a diameter as large as 25 µm. In this case, the cross-sectional area of the wire used for the first electrode pad 4a is about 1.56 times that of the wire used for the second electrode pad 4b. Thus, the bonding strength can be improved in accordance with an increase in the cross-sectional area. This can improve the bonding strength of wire bonding to the first electrode pad 4a and improve the reliability of the wire bonding. This can improve the reliability and quality of the optical printer head including this light-emitting element array 1.

To increase the area of the first electrode pad 4a as compared with the area of the second electrode pad 4b, both the length (the distance defined between the first long side 2a and the second long side 2b) and the width (the distance defined along the second long side 2b) of the first electrode pad 4a may be increased as illustrated in the example of FIG. 1. When the width of the first electrode pad 4a is increased, the wire having a larger diameter than the wire used for the second electrode pad 4b can be used. When the length of the second electrode pad 4b is increased, the wire having a larger diameter than the wire used for the second electrode pad 4b can be used, thus allowing wire bonding at a position slightly distant from the second long side 2b. This improves the transmission of an ultrasonic wave during wire bonding to increase the intensity.

The size of each electrode pad 4 to receive a wire using wire bonding may be set to a size appropriate for a wire bonding pad, allowing the size of the electrode pads 4 to be unchanged depending on the density of the light-emitting elements 3. However, when, for example, the density of the light-emitting elements 3 is increased from 300 to 600 dpi, the number of electrode pads 4 is increased twice. When the density is further increased from 600 dpi to high density of 1200 dpi, the number of electrode pads 4 is increased twice. Thus, the electrode pads 4 cannot be arranged fully in a row although the size of the electrode pads 4 is changed in arrangement of the electrode pads 4 in a row along the second long side 2b of the semiconductor substrate 2. In this case, the electrode pads 4 can be densely arranged in two to four rows, for example, in three rows as illustrated in the example of FIG. 1, along the second long side 2b depending on the density of the light-emitting elements 3.

For example, the electrode pads 4 (the second electrode pads 4b) each typically have a width of about 60 µm and a length of about 100 µm. In the example illustrated in FIG. 1, each electrode pad 4 has an octagonal shape obtained by cutting the four corners off from a rectangle. The electrode pads 4 may have a rectangular shape. In both cases, the electrode pads 4 are set to have a similar width and length.

In contrast, the first electrode pad 4a in a row closest to the second long side 2b of the semiconductor substrate 2 in the light-emitting element array 1 has, for example, a width of 65 to 85 µm and a length of 100 to 140 µm, and has a larger area than a second electrode pad 4b in another row.

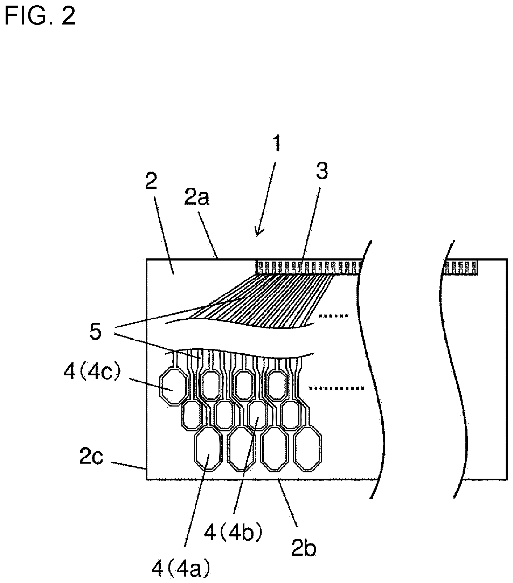

In some embodiments of the present disclosure, among the electrode pads 4 in the rows in the light-emitting element array 1, a third electrode pad 4c is at an end of the rows closest to a first short side 2c or a second short side (no reference numeral) of the semiconductor substrate 2 (a portion near the second short side is not illustrated). The third electrode pad 4c may have a larger area than a second electrode pad 4b as illustrated in FIG. 2, which is the same as or similar to the plan view of FIG. 1. FIG. 2 is a plan view of a second example of the light-emitting element array according to one or more embodiments of the present disclosure. In FIG. 2, a component having the same or similar structure and function to those in FIG. 1 is given the same reference numeral, and will not be described repeatedly.

Among the electrode pads 4, the electrode pad 4 (the third electrode pad 4c) closest to the first short side 2c or the second short side of the semiconductor substrate 2 is close to an end of the semiconductor substrate 2, similarly to the first electrode pads 4a in the row closest to the second long side 2b, and thus is less likely to transmit an ultrasonic wave. This tends to decrease the bonding strength of the wire. However, the third electrode pad 4c at the end of the rows closest to the first short side 2c or the second short side has a larger area than a second electrode pad 4b. An increase in the intensity of an ultrasonic wave in the third electrode pad 4c with a larger area can thus improve the bonding strength. In some embodiments, the wire having a larger diameter than the wire used for the second electrode pad 4b can be used for the third electrode pad 4c, thus improving the bonding strength.

The second short side of the semiconductor substrate 2 is a short side opposite to the first short side 2c, and is a right short side in FIG. 2. However, the right and left short sides may not be distinguished, and the short side 2c illustrated in FIG. 2 may be the second short side.

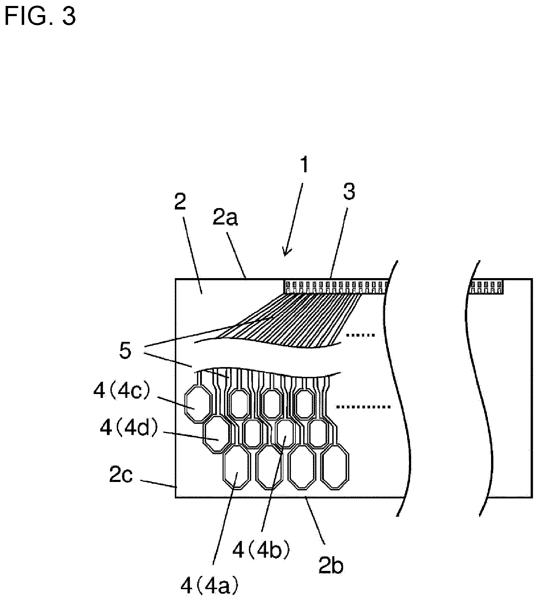

In some embodiments of the present disclosure, among the electrode pads 4 in the rows in the light-emitting element array 1, a fourth electrode pad 4d is between the first electrode pad 4a in the row closest to the second long side 2b of the semiconductor substrate 2 and the third electrode pad 4c at the end of the rows closest to the first short side 2c or the second short side. The fourth electrode pad 4d has a larger area than a second electrode pad 4b as illustrated in FIG. 3, which is the same as or similar to the plan views of FIGs. 1 and 2. FIG. 3 is a plan view of a third example of the light-emitting element array according to one or more embodiments of the present disclosure. In FIG. 3, a component having the same or similar structure and function to those in FIGs. 1 and 2 is given the same reference numeral, and will not be described repeatedly.

Among the electrode pads 4, the fourth electrode pad 4d between the first electrode pad 4a in the row closest to the second long side 2b of the semiconductor substrate 2 and the third electrode pad 4c at the end of the rows closest to the first short side 2c or the second short side is also close to an end of the semiconductor substrate 2. Thus, the fourth electrode pad 4d is less likely to transmit an ultrasonic wave although the fourth electrode pad 4d is less susceptible to a decrease in ultrasonic wave transmission than the first electrode pad 4a and the third electrode pad 4c. This tends to decrease the bonding strength of the wire. The fourth electrode pad 4d at the end of the rows of the electrode pads 4 has a larger area than a second electrode pad 4b. An increase in the intensity of an ultrasonic wave in the fourth electrode pad 4d with a larger area can thus improve the bonding strength. In some embodiments, the wire having a larger diameter than the wire used for the second electrode pad 4b can be used for the fourth electrode pad 4d, thus improving the bonding strength.

In some embodiments of the present disclosure, the light-emitting element array 1 includes the first electrode pad 4a having a width in a direction along the second long side 2b greater than or equal to the width of the second electrode pad 4b in the direction along the second long side 2b and greater than the length of the second electrode pad 4b in a direction orthogonal to the second long side 2b. This allows, for the first electrode pad 4a, effective use of the wire having a larger diameter than the wire used for the second electrode pad 4b. This also increases the area of the first electrode pad 4a near the second long side 2b.

In some embodiments of the present disclosure, the light-emitting element array 1 includes the first electrode pad 4a having a length in the direction orthogonal to the second long side 2b greater than or equal to the length of the second electrode pad 4b in the direction orthogonal to the second long side 2b and greater than the width of the first electrode pad 4a in the direction along the second long side 2b. This structure uses the relationship between the first electrode pad 4a and the second electrode pad 4b in the examples of FIGs. 1 to 3. This allows, for the first electrode pad 4a, effective use of the wire having a larger diameter than the wire used for the second electrode pad 4b. This also allows efficient arrangement of the first electrode pads 4a each having a large area in a restricted space when the first electrode pads 4a cannot be widely spaced from the adjacent first electrode pads 4a.

In some embodiments of the present disclosure, the light-emitting element array 1 includes the third electrode pad 4c having a width in the direction along the second long side 2b greater than or equal to the width of the second electrode pad 4b in the direction along the second long side 2b and greater than the length of the second electrode pad 4b in a direction along the first short side 2c or the second short side. This allows, for the third electrode pad 4c, effective use of the wire having a larger diameter than the wire used for the second electrode pad 4b. This also achieves sufficient intensity for an ultrasonic wave applied to the third electrode pad 4c near the first short side 2c or the second short side.

In some embodiments of the present disclosure, the light-emitting element array 1 includes the third electrode pad 4c having a length in the direction along the first short side 2c or the second short side greater than or equal to the length of the second electrode pad 4b in the direction orthogonal to the second long side 2b and greater than the width of the third electrode pad 4c in the direction along the second long side 2b. This structure uses the relationship between the third electrode pad 4c and the second electrode pad 4b in the examples of FIGs. 2 and 3. This allows, for the third electrode pad 4c, effective use of the wire having a larger diameter than the wire used for the second electrode pad 4b. This also increases the area of the third electrode pad 4c near the first short side 2c or the second short side.

The same relationship as for the size between the second electrode pad 4b and the first electrode pad 4a and the relationship as for the size between the second electrode pad 4b and the third electrode pad 4c as described above can be used for the fourth electrode pad 4d. Thus, the wire having a larger diameter than the wire used for the second electrode pad 4b is used or an ultrasonic wave with a higher intensity than the ultrasonic wave applied to the second electrode pad 4b is used for the first electrode pads 4a in the row closest to the second long side 2b, for the third electrode pad 4c at the end of the rows closest to the first short side 2c or the second short side, and for the fourth electrode pad 4d between the first electrode pad 4a and the third electrode pad 4c and at the end of the rows closest to the first short side 2c or the second short side among the electrode pads 4 in the rows. This improves the bonding strength of wire bonding.

In some embodiments of the present disclosure, each first electrode pad 4a in the light-emitting element array 1 has a greater thickness than the second electrode pad 4b, or more specifically, is thick. In some embodiments, the third electrode pad 4c has a greater thickness than the second electrode pad 4b. In some embodiments, the fourth electrode pad 4d has a greater thickness than the second electrode pad 4b. In wire bonding for the first electrode pad 4a, the third electrode pad 4c, or the fourth electrode pad 4d, the wire having a larger diameter than the wire used for the second electrode pad 4b is used or an ultrasonic wave with a higher intensity than the ultrasonic wave in the second electrode pad 4b is applied. This improves the durability under severer bonding conditions. This can stably perform wire bonding with improved bonding strength.

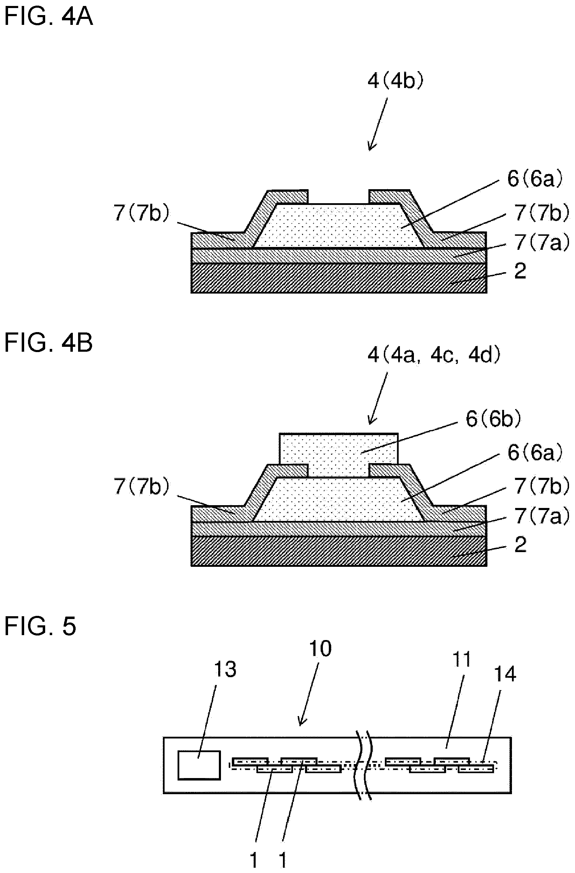

FIGs. 4A and 4B illustrate examples of the first electrode pad 4a, the third electrode pad 4c, or the fourth electrode pad 4d having a greater thickness (being thicker) than the second electrode pad 4b in the embodiments as described above. FIGs. 4A and 4B are each a cross-sectional view of an example electrode pad in the light-emitting element array according to one or more embodiments of the present disclosure. FIG. 4A is a schematic diagram of the second electrode pad 4b. FIG. 4B is a schematic diagram of the first electrode pad 4a, the third electrode pad 4c, or the fourth electrode pad 4d.

The electrode pad 4 (the second electrode pad 4b) illustrated in FIG. 4Aincludes, for example, a conductor layer 6 (a first conductor layer 6a) on the upper surface of the semiconductor substrate 2 with an insulating layer 7 (a first insulating layer 7a) in between. For example, the conductor layer 6 is made of a conductive material such as aluminum (Al), copper (Cu), nickel (Ni), chromium (Cr), silver (Ag), or gold (Au). For example, the semiconductor substrate 2 is made of a semiconductor material such as silicon (Si), gallium arsenide (GaAs), or aluminum gallium arsenide (AlGaAs). For example, the insulating layer 7 is made of silicon nitride (SiN). The conductor layer 6 is a portion corresponding to a pad surface of the second electrode pad 4b. The insulating layer 7 (a second insulating layer 7b) of, for example, silicon nitride, which functions as a protective layer, surrounds the conductor layer 6. A portion used as the pad surface of the second electrode pad 4b is exposed through an opening in the insulating layer 7. The second electrode pad 4b has a thickness substantially corresponding to the thickness of the conductor layer 6 (the first conductor layer 6a).

In contrast, the electrode pad 4 (the first electrode pad 4a, the third electrode pad 4c, or the fourth electrode pad 4d) illustrated in FIG. 4B includes the conductor layer 6 (the first conductor layer 6a) on the upper surface of the semiconductor substrate 2 with the insulating layer 7 (the first insulating layer 7a) in between, similarly to the second electrode pad 4b illustrated in FIG. 4A. The insulating layer 7 (the second insulating layer 7b) having an opening through which the portion used as the pad surface is exposed surrounds the conductor layer 6. The conductor layer 6 (a second conductor layer 6b) that is the portion used as the pad surface is stacked on the first conductor layer 6a through the opening. The first electrode pad 4a, the third electrode pad 4c, or the fourth electrode pad 4d has a thickness substantially corresponding to the total thickness of the first conductor layer 6a and the second conductor layer 6b that are stacked on each other. Thus, the first electrode pad 4a, the third electrode pad 4c, or the fourth electrode pad 4d can have a greater thickness than the second electrode pad 4b. This improves the durability in wire bonding and the bonding strength.

Both the electrode pads 4 illustrated in FIGs. 4A and 4B can be formed by photolithography. In the first electrode pad 4a, the third electrode pad 4c, or the fourth electrode pad 4d, the first conductor layer 6a may be formed to have a greater thickness than the second electrode pad 4b. Thus, the thickness of the first conductor layer 6a can be increased with the same structure as the second electrode pad 4b. In this case as well, the electrode pads 4 can be formed by photolithography.

The thickness of the electrode pads 4 may be appropriately set, for example, in accordance with the drive power supplied to the light-emitting element 3, the material for the conductor layer 6, the material and the diameter of the wire to be bonded, and the bonding condition of wire bonding. When the second electrode pad 4b has a thickness of, for example, about 0.7 µm, the first electrode pad 4a, the third electrode pad 4c, or the fourth electrode pad 4d may have a greater thickness of, for example, about 1.5 µm. In this case, in wire bonding using the wire having a larger diameter than the wire used for the second electrode pad 4b under stronger bonding conditions, the durability can be improved. This can stably perform wire bonding with improved bonding strength.

FIG. 5 is a plan view of an example optical printer head including the light-emitting element array 1 according to one or more embodiments of the present disclosure. Multiple light-emitting element arrays 1 are mounted in a row on a circuit board 11 in an optical printer head 10. The light-emitting element arrays 1 are arranged in two rows alternately facing each other in a main scanning direction, or more specifically, in a staggered manner, and the light-emitting elements 3 are arranged in a row. A drive circuit 13 supplies various drive signals that control the emission of light from the light-emitting elements 3 in the light-emitting element arrays 1 and functions as a constant current power supply. Wires electrically connecting the drive circuit 13 to each of the light-emitting element arrays 1 are not illustrated in the figure. The wires are connected to the electrode pads 4 in the light-emitting element arrays 1 by wire bonding. In some embodiments, drive ICs (integrated circuits) may be located near the corresponding light-emitting element arrays 1, and electrode pads in each drive IC may be connected to the electrode pads 4 in the corresponding light-emitting element array 1 by wire bonding.

A lens unit 14 indicated by a dot-dash line is located above the light-emitting element arrays 1 (corresponding to a front side in FIG. 5). The lens unit 14 is optically coupled to the light-emitting element arrays 1 to guide light emitted from the light-emitting elements 3 in the light-emitting element arrays 1 to a surface of an electrophotographic photoreceptor in an image forming apparatus. The lens unit 14 is held to face the light-emitting element arrays 1 with a member not illustrated in the figure. The lens unit 14 uses, for example, a rod lens array including multiple rod lenses. A rod lens is a rod-like lens with a distributed refractive index, and functions as an erect equal magnification optical system. The erect equal magnification optical system applies incident light with the same magnification to an illumination surface such as the surface of the electrophotographic photoreceptor to form an image. The lens unit 14 includes lenses arranged in a row in the main scanning direction substantially immediately above a light-emitting diode group, for example, in a linear row or in two rows arranged in a staggered manner to correspond to the light-emitting diode group in the light-emitting elements 3 in the light-emitting element arrays 1.

The optical printer head 10 includes other components such as an outer casing and a connection cable to an external control circuit. The optical printer head 10 according to the embodiments of the present disclosure includes the light-emitting element arrays 1 according to the embodiments of the present disclosure, and thus uses wire bonding with improved bonding strength to achieve high reliability of the light-emitting element arrays 1. The optical printer head 10 can have high reliability.

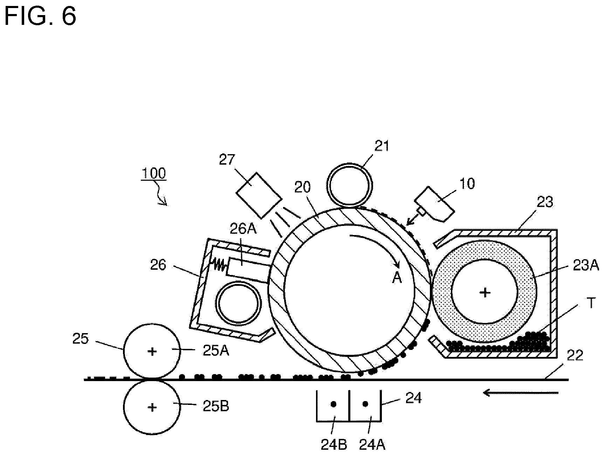

FIG. 6 is a schematic cross-sectional view of an example image forming apparatus according to one or more embodiments of the present disclosure. An image forming apparatus 100 in the example uses Carlson's electrophotography as an image forming process. As illustrated in FIG. 6, the image forming apparatus 100 includes an electrophotographic photoreceptor (photoreceptor) 20, a charger 21, the optical printer head 10 as an exposure device, a developing device 23, a transfer device 24, a fuser 25, a cleaner 26, and a static eliminator 27.

The charger 21 can positively or negatively charge the surface of the photoreceptor 20 that rotates in a direction indicated by an arrow A in FIG. 6. The charged negative voltage is set to, for example, -1000 V or greater and -200 V or less. The charger 21 in the example is, for example, a contact charger including a core metal covered with conductive rubber and polyvinylidene fluoride. In some embodiments, the charger 21 may be a contactless charger (e.g., a corona charger) including a discharge wire.

The optical printer head 10 can expose the charged surface of the photoreceptor 20 to light to form an electrostatic latent image on the photoreceptor 20. More specifically, the optical printer head 10 illuminates the uniformly charged surface of the photoreceptor 20 with exposure light having a wavelength λ that is sufficiently absorbed by a photoreceptor layer in the photoreceptor 20 in accordance with an image signal (when the photoreceptor layer includes an amorphous silicon material, for example, the wavelength is 650 nm) to attenuate the potential of the exposed portion of the charged photoreceptor 20 and to form an electrostatic latent image. The wavelength λ of the exposure light is specifically 400 to 680 nm, for example, depending on the photosensitivity of the photoreceptor 20.

A constant current power supply (not illustrated) is connected to the optical printer head 10. The constant current power supply supplies drive power for driving the light-emitting elements 3 and emitting light under electric connection to each of the electrode pads 4 through the drive circuit 13. In the optical printer head 10, a control circuit is electrically connected to the drive circuit 13 to supply drive signals (control signals) for driving the light-emitting elements 3 in accordance with a pattern of an image to be formed.

The developing device 23 can develop the electrostatic latent image on the photoreceptor 20 to form a toner image. The developing device 23 in the example is a device for a dry development process, and includes a magnetic roller 23A that magnetically holds a developer (toner) T.

The developer T forms a toner image on the surface of the photoreceptor 20. The developing device 23 charges the developer T in a triboelectric state. Examples of the developer T include a two-component developer including a magnetic carrier and insulating toner, and a one-component developer including magnetic toner.

The magnetic roller 23A can transport the developer T to the surface (a development region) of the photoreceptor 20. The magnetic roller 23A transports the developer T charged in a triboelectric manner with the developing device 23 including a magnetic brush adjusted to a predetermined brush length. The transported developer T adheres to the surface of the photoreceptor 20 in the development region of the photoreceptor 20 under electrostatic attraction of the electrostatic latent image to form the toner image. This visualizes the electrostatic latent image. The charged polarity of the toner image is reverse to the charged polarity of the surface of the photoreceptor 20 during formation of an image through normal development. The charged polarity of the toner image is the same as the charged polarity of the surface of the photoreceptor 20 during formation of an image through reversal development.

The developing device 23 may be a developing device for a liquid development process. The developing device for a liquid development process includes a tank for storing a liquid developer containing toner outside the developing device. The liquid developer includes toner particles and a carrier liquid that is an insulating liquid. The carrier liquid is a non-polar solvent such as silicone oil, or in other words, an electrically neutral solvent. The toner particles are dispersed at a high concentration in the carrier liquid. The toner particles include a binder resin such as epoxy, a charge controller that imparts a predetermined charge to the toner, and a colored pigment, for example.

The developing device for a liquid development process includes a unit that supplies a liquid developer to the development roller. The development roller to which the liquid developer is supplied comes into contact with the surface of the photoreceptor 20, and supplies the liquid developer to the surface of the photoreceptor 20. The development roller that is a developer-support supplies the liquid developer to the photoreceptor 20 having the electrostatic latent image to form the toner image on the photoreceptor 20.

The transfer device 24 can transfer the toner image on the photoreceptor 20 to a recording medium 22 such as a sheet that is supplied to a transfer region between the photoreceptor 20 and the transfer device 24. The transfer device 24 in the example includes a transfer electrical discharger 24A and a separation electrical discharger 24B. The transfer device 24 uses the transfer electrical discharger 24A to charge a back surface (non-recording surface) of the recording medium 22 with a polarity reverse to that of the toner image to transfer the toner image on the recording medium 22 under electrostatic attraction between the charge and the toner image. At the same time as the transfer of the toner image, the transfer device 24 uses the separation electrical discharger 24B to eliminate the charge on the back surface of the recording medium 22 under alternating current discharge. This separates the recording medium 22 readily from the surface of the photoreceptor 20.

The transfer device 24 may be a transfer roller that follows the rotation of the photoreceptor 20 and is spaced from the photoreceptor 20 at a small interval (usually 0.5 mm or less). For example, the transfer roller applies, to the recording medium 22, a transfer voltage generated by, for example, a direct current power supply to attract the toner image on the photoreceptor 20. When the transfer roller is used, a transfer separation device such as the separation electrical discharger 24B can be eliminated.

The fuser 25 can fix, on the recording medium 22, the toner image transferred onto the recording medium 22. The fuser 25 includes a pair of fuser rollers 25A and 25B. The fuser rollers 25A and 25B are, for example, metal rollers each having a surface covered with, for example, polytetrafluoroethylene. The fuser 25 applies, for example, heat and pressure to the recording medium 22 passing between the fuser rollers 25A and 25B. Thus, the toner image can be fixed on the recording medium 22.

The cleaner 26 can remove toner remaining on the surface of the photoreceptor 20 after the transfer. The cleaner 26 in the example includes a cleaning blade 26A. The cleaning blade 26A can scrape the residual toner from the surface of the photoreceptor 20. The cleaning blade 26A is made of, for example, a rubber material mainly containing a polyurethane resin.

The static eliminator 27 can remove the surface charge of the photoreceptor 20 that remains as the electrostatic latent image. The static eliminator 27 in the example eliminates static electricity by exposure of the photoreceptor 20 to light. The static eliminator 27 can emit light having a specific wavelength (e.g., 780 nm or greater). The static eliminator 27 eliminates the surface charge of the photoreceptor 20 (residual electrostatic latent image) by, for example, illuminating the entire surface in an axial direction of the surface of the photoreceptor 20 with light using a light source such as a light-emitting diode.

The image forming apparatus 100 according to the embodiments of the present disclosure includes the optical printer head 10 according to the embodiments of the present disclosure, and thus uses wire bonding with improved bonding strength to achieve high reliability of the light-emitting element arrays 1. The image forming apparatus can obtain a high-quality image and has high reliability.

The present disclosure is not limited to the embodiments described above, and may be, for example, changed or modified variously without departing from the spirit and scope of the present disclosure.

### REFERENCE SIGNS

- 1: light-emitting element array
- 2: semiconductor substrate
- 2a: first long side
- 2b: second long side
- 2c: first short side
- 3: light-emitting element
- 4: electrode pad
- 4a: first electrode pad
- 4b: second electrode pad
- 4c: third electrode pad
- 4d: fourth electrode pad
- 5: wire
- 6: conductor layer
- 6a: first conductor layer
- 6b: second conductor layer
- 7: insulating layer
- 7a: first insulating layer
- 7b: second insulating layer
- 10: optical printer head
- 11: circuit board
- 13: drive circuit
- 14: lens unit
- 20: electrophotographic photoreceptor (photoreceptor)
- 100: image forming apparatus

## Claims

1. A light-emitting element array, comprising:
a semiconductor substrate that is rectangular;
a plurality of light-emitting elements on the semiconductor substrate in a row along a first long side of the semiconductor substrate;
a plurality of electrode pads on the semiconductor substrate in a plurality of rows along a second long side of the semiconductor substrate, the plurality of electrode pads corresponding one to one to the plurality of light-emitting elements; and
a plurality of wires on the semiconductor substrate, the plurality of wires each connecting a corresponding light-emitting element of the plurality of light-emitting elements to a corresponding electrode pad of the plurality of electrode pads,
wherein the plurality of electrode pads in the plurality of rows includes a first electrode pad in a row of the plurality of rows closest to the second long side and having a larger area than a second electrode pad in another row of the plurality of rows.

2. The light-emitting element array according to claim 1, wherein
the plurality of electrode pads in the plurality of rows includes a third electrode pad that is at an end of the plurality of rows closest to a first short side or a second short side of the semiconductor substrate, the third electrode pad having a larger area than the second electrode pad.

3. The light-emitting element array according to claim 1 or claim 2, wherein
the first electrode pad has, in a direction along the second long side, a width greater than or equal to a width of the second electrode pad in the direction along the second long side, and greater than a length of the second electrode pad in a direction orthogonal to the second long side.

4. The light-emitting element array according to claim 1 or claim 2, wherein
the first electrode pad has, in a direction orthogonal to the second long side, a length greater than or equal to a length of the second electrode pad in the direction orthogonal to the second long side, and greater than a width of the first electrode pad in a direction along the second long side.

5. The light-emitting element array according to claim 2, wherein
the third electrode pad has, in a direction along the second long side, a width greater than or equal to a width of the second electrode pad in the direction along the second long side, and greater than a length of the second electrode pad in a direction along the first short side or the second short side.

6. The light-emitting element array according to claim 2, wherein
the third electrode pad has, in a direction along the first short side or the second short side, a length greater than or equal to a length of the second electrode pad in a direction orthogonal to the second long side, and greater than a width of the third electrode pad in a direction along the second long side.

7. The light-emitting element array according to claim 1, wherein
the first electrode pad has a greater thickness than the second electrode pad.

8. The light-emitting element array according to claim 2, wherein
the third electrode pad has a greater thickness than the second electrode pad.

9. An optical printer head, comprising:
the light-emitting element array according to any one of claims 1 to 8;
a drive circuit electrically connected to the light-emitting element array to drive the plurality of light-emitting elements; and
a lens unit optically coupled to the light-emitting element array.

10. An image forming apparatus, comprising:
the optical printer head according to claim 9;
a drive power supply electrically connected to the drive circuit to drive the plurality of light-emitting elements; and
an electrophotographic photoreceptor having a surface configured to be charged and exposed to light by the optical printer head.
